# EUROPÄISCHE PATENTANMELDUNG

(11) **EP 4 231 459 A1**
(43) Veröffentlichungstag der Anmeldung: **23.08.2023**
(21) Anmeldenummer: 23155358.7
(22) Anmeldetag: 07.02.2023
(51) Int. Cl.: H01R 12/72, H01R 4/48, H01R 12/57, H05K 3/34, H01R 12/51

(54) **ANSCHLUSSVORRICHTUNG UND VERBINDUNGSEINHEIT**

(30) Priorität: 18.02.2022 DE 102022103851
(71) Anmelder: Weidmüller Interface GmbH & Co. KG, 32758 Detmold (DE)
(72) Erfinder: SCHUMACHER, Ralf, 32657 Lemgo (DE); DIEKMANN, Torsten, 33818 Leopoldshöhe (DE); SMITH, Christopher, 33803 Steinhagen (DE); NIGGEMANN, Matthias, 32694 Dörentrup (DE); OESTERHAUS, Jens, 32760 Detmold (DE)
(74) Vertreter: Specht, Peter

(57) **Zusammenfassung**

Eine Anschlussvorrichtung (1) zur Verbindung mindestens eines elektrischen Leiters (L) mit mindestens einer elektrisch leitenden Kontaktfläche (6) einer Leiterplatte (5), umfasst ein Gehäuse (1a), mindestens eine erste Verbindungseinheit (2) und mindestens eine zweite Verbindungseinheit (3), wobei die Anschlussvorrichtung (1) eine SMD-fähige Kontaktgeometrie aufweist. Die SMD-fähige Kontaktgeometrie weist mindestens einen ersten Leiterplattenkontakt (4) und mindestens einen zweiten Leiterplattenkontakt (4') mit jeweils einem Federarm (18, 18') mit einem jeweiligen Kontaktvorsprung (20, 20') auf.

## Beschreibung

Die Erfindung betrifft eine Anschlussvorrichtung nach dem Oberbegriff des Anspruchs 1. Die Erfindung bezieht sich auch auf eine Verbindungseinheit einer solchen Anschlussvorrichtung.

Eine derartige Anschlussvorrichtung wird zum Anschluss eines elektrischen Leiters an eine Leiterplatte eingesetzt. Die Anschlussvorrichtung umfasst Verbindungseinheiten, an die einerseits der elektrische Leiter angeschlossen werden kann, z.B. mittels einer Klemme, und die andererseits eine geeignete Verbindungsmöglichkeit für Kontaktflächen der Leiterplatte aufweisen, z.B. Federkontakte. Die Kontaktflächen der Leiterplatte sind üblicherweise aus Kupfer. Sie können auch verzinnt, versilbert oder vergoldet sein.

Im Zuge einer Miniaturisierung der Bauteile, mit denen die Leiterplatte bestückt wird, werden so genannte SMD-Bauteile (Surface Mounted Devices) von geringer Größe verwendet, die auf die zugehörigen für SMD-Lötverfahren (z.B. Infrarot, Heißluft, Dampfphase, u.dgl.) vorbereiteten Kupferflächen (SMD-Löt-Pads) aufgelegt, evtl. mit Kleber befestigt, und dann mit den geeigneten SMD-Lötverfahren an den zugehörigen SMD-Löt-Pads angelötet werden.

Ein kontinuierlich steigender Bedarf für Anschlussvorrichtungen, z.B. in Automatisierungsbereichen, für unterschiedliche Leiter an Leiterplatten, insbesondere Leiterplatten im SMD Bereich ergibt die Forderung nach verbesserten Anschlussvorrichtungen hinsichtlich Lötfähigkeit mittels der SMD-Lötverfahren, kompakter Bauweise sowie sicherer und einfacher Handhabung.

Die Aufgabe der vorliegenden Erfindung besteht daher darin, eine verbesserte Anschlussvorrichtung für Leiter an SMD bestückten Leiterplatten zu schaffen.

Eine weitere Aufgabe ist es, eine verbesserte Anschlussvorrichtung bereitzustellen.

Die Aufgabe wird durch eine Anschlussvorrichtung mit den Merkmalen des Anspruchs 1 gelöst.

Die weitere Aufgabe wird durch eine Verbindungseinheit mit den Merkmalen des Anspruchs 13 gelöst.

Eine erfindungsgemäße Anschlussvorrichtung zur Verbindung mindestens eines elektrischen Leiters mit mindestens einer elektrisch leitenden Kontaktfläche einer Leiterplatte umfasst ein Gehäuse, mindestens eine erste Verbindungseinheit und mindestens eine zweite Verbindungseinheit, wobei die Anschlussvorrichtung eine SMD-fähige Kontaktgeometrie aufweist. Die SMD-fähige Kontaktgeometrie weist mindestens einen ersten Leiterplattenkontakt und mindestens einen zweiten Leiterplattenkontakt mit jeweils einem Federarm mit einem jeweiligen Kontaktvorsprung auf.

Ein besonderer Vorteil der SMD-fähigen Kontaktgeometrie besteht darin, dass die Anschlussvorrichtung mit den Leiterplattenkontakten einerseits in einfacher Weise auf die Kontaktflächen der Leiterplatte aufgeschoben werden kann. Andererseits ermöglichen die Kontaktvorsprünge vorteilhaft die Einhaltung eines erforderlichen Lötspaltes zwischen den Kontaktflächen der Leiterplatte und dem jeweiligen Federarm der Leiterplattenkontakte.

Der Begriff Leiterplatte schließt auch einseitig kaschierte Leiterplatten, doppelseitig kaschierte Leiterplatten, Multilayer-Leiterplatten, Leiterplatten mit Metallkern, flexible Leiterplatten u.dgl. mit ein.

Eine erfindungsgemäße Verbindungseinheit der oben beschriebenen Anschlussvorrichtung zur Verbindung mindestens eines elektrischen Leiters mit mindestens einer elektrisch leitenden Kontaktfläche einer Leiterplatte, einer Federklemme und einem Leiterplattenkontakt weist eine Grundplatte mit einer ersten Seitenwand und mit einer zweiten Seitenwand auf, wobei die erste Seitenwand und die zweite Seitenwand parallel zueinander und rechtwinklig an der Grundplatte angebracht und durch die Grundplatte elektrisch leitend verbunden sind. Dies ergibt den Vorteil eines kompakten und einfachen Aufbaus. Zudem wird die Grundplatte durch die Seitenwände vorteilhaft versteift.

In einer Ausführung ist es vorgesehen, dass die Kontaktvorsprünge jeweils einen Punktkontakt bilden. Dies ergibt den besonderen Vorteil gegenüber üblichen Linien-kontakten, dass das auf den Kontaktflächen befindliche Flussmittel oder die Lotpaste weder entfernt noch weggeschoben oder reduziert wird, außer im Bereich der Kontaktvorsprünge.

Alternativ können die Kontaktvorsprünge jeweils einen Linienkontakt bilden, der sich in Steckrichtung der Anschlussvorrichtung erstreckt. Der Linienkontakt kann durchgehend oder unterbrochen sein, wobei er dabei aus mehreren Teillinienstücken besteht. Es können auch mehrere Punktkontakte sich hintereinander in Reihe in Steckrichtung der Anschlussvorrichtung erstreckend als Kontaktvorsprung vorgesehen sein. Auch eine Kombination aus Punkt-Linien-Kontakten ist möglich. Diese Ausführungen ergeben alle den Vorteil, dass das auf den Kontaktflächen befindliche Flussmittel oder die Lotpaste nur im Bereich der Kontaktvorsprünge weggeschoben oder reduziert wird, wobei die restliche Kontaktfläche mit Flussmittel oder Lotpaste bedeckt bleibt.

In einer weiteren Ausführung sind der mindestens eine erste Leiterplattenkontakt mit dem einen Kontaktvorsprung und der mindestens eine zweite Leiterplattenkontakt mit dem einen Kontaktvorsprung gegenüberstehend angeordnet, wobei sie einen Anschlussraum zur Aufnahme eines Anschlussbereichs der zuzuordnenden Leiterplatte zwischen sich festlegen. Damit wird es vorteilhaft ermöglicht, dass die Anschlussvorrichtung nicht auf einer Leiterplattenseite wie die anderen SMD-Bauteile positioniert werden muss, sondern an einem Rand der Leiterplatte aufgeschoben bzw. aufgesteckt sein kann.

Es ist vorteilhaft, dass der Anschlussraum weiterhin durch einen Mittelsteg des Gehäuses der Anschlussvorrichtung begrenzt ist, da so ein Anschlag für die Positionierung der Anschlussvorrichtung auf der Leiterplatte ermöglicht wird.

Vorteilhafte Weiterbildungen der Erfindung sind durch die Unteransprüche angegeben.

Eine noch weitere Ausführung sieht vor, dass die mindestens eine erste Verbindungseinheit und die mindestens eine zweite Verbindungseinheit jeweils in einer Aufnahme des Gehäuses eingesetzt sind, wobei eine jede Aufnahme mindestens eine erste Öffnung an einer Oberseite des Gehäuses für den mindestens einen elektrischen Leiter und mindestens eine zweite Öffnung, durch welche sich der Federarm des jeweiligen Leiterplattenkontaktes hindurch erstreckt, an einer Unterseite des Gehäuses aufweist. Damit werden die Verbindungseinheiten in der Anschlussvorrichtung in richtiger Position vorteilhaft einem verwendeten Rastermaß der Kontaktflächen der Leiterplatte entsprechend voneinander isoliert angeordnet.

In einer weiteren Ausführung ist der Federarm des ersten Leiterplattenkontaktes an einer ersten Seitenwand der mindestens einen ersten Verbindungseinheit angebracht, und der Federarm des zweiten Leiterplattenkontaktes ist an einer zweiten Seitenwand der mindestens einen zweiten Verbindungseinheit angebracht. Auf diese Weise kann ein Grundaufbau der Verbindungseinheit für beide Verbindungseinheiten vorteilhaft genutzt werden, wobei die Aufnahmen der Anschlussvorrichtung vorteilhaft identisch ausgebildet sein können.

In einer noch weiteren Ausführung sind die mindestens eine erste Verbindungseinheit und die mindestens eine zweite Verbindungseinheit derart in benachbarten Aufnahmen angeordnet, dass ein Mittelsteg des Gehäuses der Anschlussvorrichtung zwischen der ersten Seitenwand der mindestens einen ersten Verbindungseinheit mit dem Federarm des ersten Leiterplattenkontaktes und der zweiten Seitenwand der mindestens einen zweiten Verbindungseinheit mit dem Federarm des zweiten Leiterplattenkontaktes angeordnet ist. Auf diese Weise ergibt sich der Vorteil eines kompakten Aufbaus, wobei gleichzeitig die Leiterplattenkontakte unter dem Mittelsteg der Anschlussvorrichtung angeordnet sind.

Eine Ausführung sieht vor, dass die mindestens eine erste Verbindungseinheit und die mindestens eine zweite Verbindungseinheit jeweils eine Grundplatte mit der ersten Seitenwand und mit der zweiten Seitenwand aufweisen, wobei die erste Seitenwand und die zweite Seitenwand parallel zueinander und rechtwinklig an der Grundplatte angebracht und durch die Grundplatte elektrisch leitend verbunden sind. Hierzu können die Verbindungseinheiten vorteilhaft als Stanzbiegeteile hergestellt werden.

In einer weiteren Ausführung weist die mindestens eine erste Verbindungseinheit und die mindestens eine zweite Verbindungseinheit jeweils eine Federklemme zum Anschluss des mindestens einen Leiters auf, wobei die Federklemme einen Federarm mit einer Kontaktkante und einer Kontaktwand umfasst, wobei die Kontaktwand die zweite Seitenwand ist. Ein Vorteil hierbei besteht darin, dass sich die Federklemme auf diese Weise mit einem kompakten Aufbau in der jeweiligen Verbindungseinheit integrieren lässt.

Dabei ist es vorteilhaft, wenn der Federarm der Federklemme über einen Bogenabschnitt mit einem Befestigungsabschnitt, welcher an der ersten Seitenwand der Grundplatte elektrisch leitend angebracht ist, verbunden ist, da so nur wenige Bauteile erforderlich sind.

Für eine vorteilhafte Handhabung beim Anschließen der elektrischen Leiter weist das Gehäuse einen Betätiger oder/und einen Betätigungskanal für ein Werkzeug zur Betätigung der Federklemme einer jeweiligen Verbindungseinheit auf.

Eine Ausführung der Verbindungseinheit sieht vor, dass die Federklemme einen Federarm mit einer Kontaktkante und einer Kontaktwand umfasst, wobei die Kontaktwand die zweite Seitenwand ist, und wobei der Federarm der Federklemme über einen Bogenabschnitt mit einem Befestigungsabschnitt, welcher an der ersten Seitenwand der Grundplatte elektrisch leitend angebracht ist, verbunden ist. Ein Vorteil hierbei besteht in einem kompakten Aufbau mit geringer Teilezahl.

In einer weiteren Ausführung der einen Verbindungseinheit ist der Federarm des Leiterplattenkontaktes an der ersten Seitenwand der Verbindungseinheit angebracht, wodurch die erste Seitenwand durch den Leiterplattenkontakt unterhalb der Federklemme verlängert ist. Dies ist vorteilhaft, da der Grundaufbau der Verbindungseinheit für die eine Verbindungseinheit und der anderen Verbindungseinheit beibehalten werden kann. Vorteilhaft ist es dafür in Ausführung der anderen Verbindungseinheit vorgesehen, dass der Federarm des Leiterplattenkontaktes an der zweiten Seitenwand der Verbindungseinheit angebracht ist, wodurch die zweite Seitenwand durch den Leiterplattenkontakt unterhalb der Federklemme verlängert ist.

Eine noch weitere Ausführung der Verbindungseinheit sieht vor, dass die Leiterplattenkontakte der Verbindungseinheiten mit Verbindungsabschnitten gekröpft ausgeführt sind. Dies erbringt den Vorteil, dass der Anschlussraum so angeordnet werden kann, dass die Oberseite der Leiterplatte unter dem Absatz 1g des Mittelsteges des Gehäuses der Anschlussvorrichtung liegt.

Ein Vorteil der Anschlussvorrichtung besteht darin, dass sie kompakt und einfach zu handhaben ist. Zudem ist ein schneller Zusammenbau ermöglicht.

Ausführungsbeispiele der Erfindung werden nachfolgend anhand der beigefügten Zeichnungen beschrieben. Diese Ausführungsbeispiele dienen lediglich der Veranschaulichung der Erfindung anhand bevorzugter Konstruktionen, welche aber die Erfindung nicht abschließend darstellen. Es sind insofern im Rahmen der Ansprüche auch andere Ausführungsbeispiele sowie Modifikationen und Äquivalente der dargestellten Ausführungsbeispiele realisierbar.
- Figur 1: eine schematische Perspektivansicht eines Ausführungsbeispiels einer erfindungsgemäßen Anschlussvorrichtung;
- Figur 2-4: schematische Perspektivansichten einer ersten erfindungsgemäßen Verbindungseinheit der Anschlussvorrichtung nach Figur 1 ;
- Figur 5: eine schematische Perspektivansichten einer zweiten erfindungsgemäßen Verbindungseinheit der Anschlussvorrichtung nach Figur 1;
- Figur 6-7: schematische Perspektivansichten der ersten und zweiten Verbindungseinheiten nach Figur 1; und
- Figur 8-9: schematische Perspektivansichten der Anschlussvorrichtung 1 nach Figur 1 in einer Verbindungsstellung.

Koordinaten x, y, z dienen zur Orientierung. Die Begriffe "Oberseite", "Unterseite", "seitlich" u.dgl. beziehen sich auf die jeweilige Anordnung in der jeweiligen Figur.

Unter dem Begriff "elektrisch leitender Kontakt" sind hier Metallflächenkontakte wie beispielsweise Kontaktflächen auf Leiterplatten/Leiterfolien, Metallflächenkontakte an Metallteilen wie beispielsweise Gehäuse, Abschirmungen, Kühlbleche, u.dgl. zu verstehen.

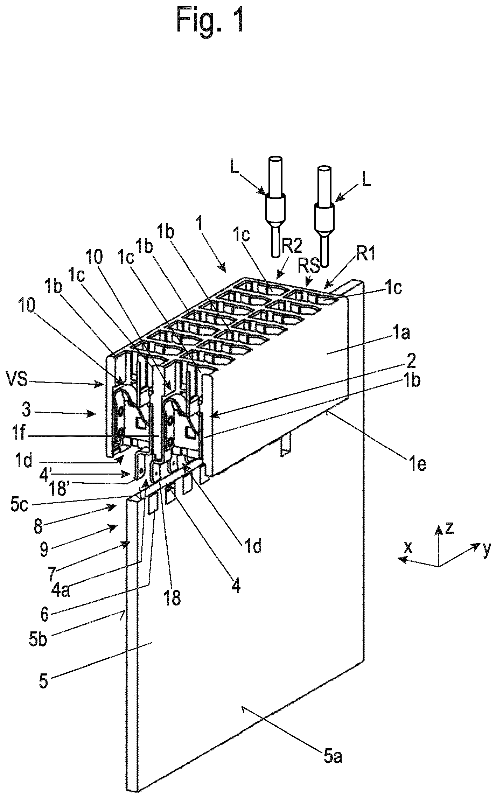

In Figur 1 ist eine schematische Perspektivansicht eines Ausführungsbeispiels einer erfindungsgemäßen Anschlussvorrichtung 1 und einer zugeordneten, beispielhaften Leiterplatte 5 dargestellt.

Die Leiterplatte 5 ist zur Bestückung mit SMD-Bauteilen (Surface Mounted Devices) auf einer oder beiden Leiterplattenseiten 5a, 5b vorgesehen. Dazu weist die Leiterplatte entsprechende SMD-Löt-Pads auf, mit denen SMD-Bauteile mittels SMD-Lötverfahren elektrisch leitend verbunden werden.

Die Anschlussvorrichtung 1 dient hier zum elektrisch leitenden Anschluss von elektrischen Leitern L an Kontaktflächen 6 der Leiterplatte 5 und weist dazu eine für SMD-Lötverfahren geeignete Kontaktgeometrie von Leiterplattenkontakten 4, 4' auf. Diese Kontaktgeometrie wird weiter unten noch ausführlich beschrieben.

Die Anschlussvorrichtung 1 wird auf einen Anschlussbereich 9 der Leiterplatte 5 aufgeschoben. Der Anschlussbereich 9 weist Kontaktanordnungen 7, 8 mit den Kontaktflächen 6 der Leiterplatte 5 auf. Die Leiterplattenkontakte 4, 4' und die Kontaktflächen 6 der Leiterplatte 5 werden dann in einem oder mehreren SMD-Lötvorgängen miteinander elektrisch leitend verbunden.

Die Kontaktflächen 6 der Leiterplatte 5 sind hier Kupferflächenabschnitte der Leiterplatte 5. In dem gezeigten Beispiel sind die Kontaktflächen 6 als SMD-Löt-Pads ausgebildet.

Die in Figur 1 schematisch gezeigte Leiterplatte 5 weist den Anschlussbereich 9 mit zwei Reihen von Kontaktanordnungen 7, 8 mit den Kontaktflächen 6 auf beiden Leiterplattenseiten 5a, 5b der Leiterplatte 5 unterhalb einer Oberseite 5c eines Randes der Leiterplatte 5 auf. Die Kontaktflächen 6 sind in einem vorher festgelegten Rastermaß in der y-Richtung angeordnet. Es ist auch möglich, dass nur eine Reihe von Kontaktanordnungen 7 oder 8 vorgesehen ist. Die Kontaktflächen 6 sind in diesem Beispiel rechteckig, können aber auch andere geometrische Formen besitzen.

Die Anschlussvorrichtung 1 umfasst ein Gehäuse 1a und mindestens eine Verbindungseinheit 2, 3. Das Gehäuse 1a weist zwei parallele Seitenwände jeweils ein einer y-z-Ebene auf, die jeweils stirnseitig mit einer Vorderseitenwand VS und einer Rückseitenwand RS verbunden sind, die jeweils in parallelen x-z-Ebenen liegen.

In dem Gehäuse 1a sind Aufnahmen 1b eingeformt. In dem gezeigten Beispiel sind zwei parallele Anschlussreihen R1 und R2 mit jeweils acht Aufnahmen 1b in dem Gehäuse 1a angeordnet. Die beiden Anschlussreihen R1 und R2 verlaufen in y-Richtung und sind untereinander durch einen Mittelsteg 1f getrennt, der einer y-z-Ebene parallel zu den Seitenwänden liegt. In y-Richtung sind die Aufnahmen 1b jeweils durch Wände getrennt, die parallel zu der Vorderseitenwand VS und der Rückseitenwand RS verlaufen. Die Vorderseitenwand VS und die Rückseitenwand RS bilden die äußeren Wände der Aufnahmen 1b, wobei hier die Vorderseitenwand VS aufgrund der Querschnittansicht der beiden vorderen Aufnahmen 1b nicht gezeigt, aber leicht vorstellbar ist.

In jeder Aufnahme 1b der beiden Anschlussreihen R1, R2 ist jeweils eine erfindungsgemäße Verbindungseinheit 2, 3 eingesetzt.

Die Aufnahmen 1b bilden gleichzeitig eine elektrische Isolierung der Verbindungseinheiten 2 untereinander.

Jede Verbindungseinheit 2, 3 verbindet einen an ihr angeschlossenen Leiter L mittels Leiterplattenkontakten 4, 4' elektrisch leitend mit einer elektrisch leitenden Kontaktfläche 6 der Leiterplatte 5.

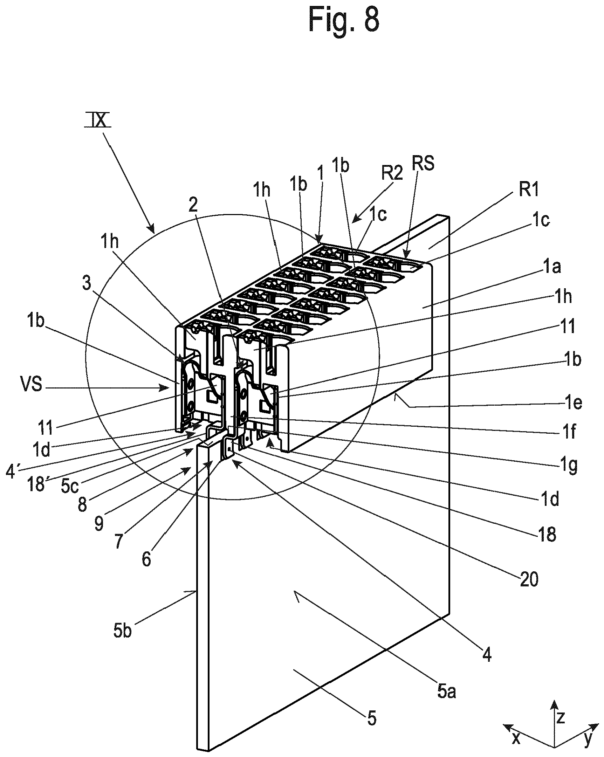

Die Leiter L werden durch erste Öffnungen 1c einer Oberseite der Anschlussvorrichtung 1 in eine jeweilige Verbindungseinheit 2, 3 eingesteckt und in dieser mittels einer Federklemme 10 elektrisch leitend geklemmt. Die Federklemme 10 ist mit einem Betätiger 1h betätigbar (siehe Figur 8). Die Federklemme 10 wird unten noch im Detail beschrieben.

Die Verbindung der jeweiligen Verbindungseinheit 2, 3 mit der jeweiligen Kontaktfläche 6 der Leiterplatte 5 wird mittels eines jeweiligen Leiterplattenkontaktes 4, 4' hergestellt. Der jeweilige Leiterplattenkontakt 4, 4' ist mit einer jeweiligen Verbindungseinheit 2, 3 elektrisch leitend verbunden. Der jeweilige Leiterplattenkontakt 4, 4' weist eine jeweilige Kontaktfeder 18, 18' auf, die durch eine zweite Öffnung 1d an einer Unterseite 1e des Gehäuses 1a nach unten, d.h. in negativer z-Richtung, hervorsteht. Die Verbindungseinheiten 2, 3 unterscheiden sich in Abhängigkeit von der Anordnung des jeweiligen Leiterplattenkontaktes 4, 4'.

Die Leiterplattenkontakte 4, 4' sind so angeordnet, dass sie sich im eingebauten Zustand der Verbindungseinheiten 2, 3 unterhalb des Mittelsteges 1f einander gegenüberstehen, wobei zwischen ihnen ein Anschlussraum 4a für die Aufnahme des Anschlussbereiches 9 der Leiterplatte 5 mit den Kontaktanordnungen 7, 8 gebildet ist.

Der Aufbau der Leiterplattenkontakte 4, 4' wird unten noch näher erläutert.

So sind erste Verbindungseinheiten 2 in der ersten Anschlussreihe R1 der Anschlussvorrichtung 1 und zweite Verbindungseinheiten 3 in der zweiten Anschlussreihe R2 der Anschlussvorrichtung 1 angeordnet.

In Figur 1 ist die Anschlussvorrichtung 1 noch nicht auf die Kontaktflächen 6 der Leiterplatte 5 aufgeschoben bzw. aufgesteckt. In dem montierten Zustand der Anschlussvorrichtung 1, der auch als Verbindungsstellung bezeichnet wird, sind die Kontaktflächen 6 der Leiterplatte 5 mit den Leiterplattenkontakten 4, 4' der Anschlussvorrichtung 1 verbunden und werden miteinander verlötet. Dazu sind die Leiterplattenkontakte 4, 4' der Anschlussvorrichtung 1 für eine SMD-Montage und - Verlötung vorgesehen. Dies wird unten noch näher beschrieben.

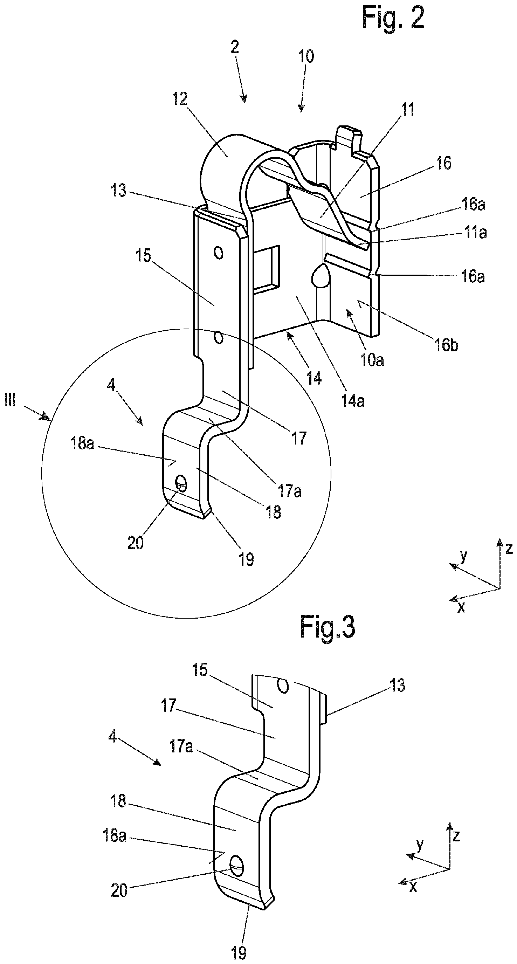

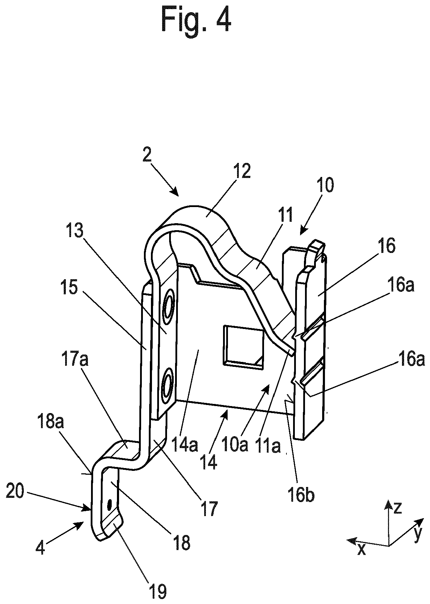

Figur 2 stellt eine schematische Perspektivansicht der erfindungsgemäßen ersten Verbindungseinheit 2 der Anschlussvorrichtung 1 nach Figur 1 dar. Figur 3 zeigt eine schematische vergrößerte Perspektivansicht eines Leiterplattenkontaktes 4 der ersten Verbindungseinheit 2 der Anschlussvorrichtung 1 des Bereiches III der Figur 1. In Figur 4 ist eine weitere schematische Perspektivansicht der Verbindungseinheit 2 nach Figur 2 aus einem anderen Blickwinkel gezeigt.

Die Verbindungseinheit 2 umfasst den Leiterplattenkontakt 4, die Federklemme 10 und eine Grundplatte 14.

Der Leiterplattenkontakt 4 und die Federklemme 10 sind an der elektrisch leitenden Grundplatte 14 angebracht. In dem gezeigten Ausführungsbeispiel ist der Leiterplattenkontakt 4 einstückig mit der Grundplatte 14 ausgebildet. Die Federklemme 10 ist aus einem separaten Federabschnitt und einer mit der Grundplatte 14 einstückig ausgebildeten Kontaktwand 16 aufgebaut. Im Folgenden wird dies detaillierter beschrieben.

Die Grundplatte 14 ist im Wesentlichen rechteckig und liegt hier in einer x-z-Ebene. An gegenüberliegenden, in z-Richtung verlaufenden Rändern der Grundplatte 14 ist jeweils eine in einer y-z-Ebene liegende Seitenwand 15, 16 angeordnet.

Diese Seitenwände 15, 16 sind hier durch Umkanten um 90° der zugehörigen Seitenabschnitte der Grundplatte 14 gebildet.

Die erste Seitenwand 15, die in der Figur 2 am linken Rand der Grundplatte 14 angeordnet ist, bildet eine Befestigungswand für die Federklemme 10 und gleichzeitig eine Anbringung des ersten Leiterplattenkontaktes 4. Dabei ist ein unterer Bereich der ersten Seitenwand 15 über Verbindungsabschnitte 17, 17a mit der ersten Kontaktfeder 18 verbunden. Der erste Leiterplattenkontakt 4 ist in diesem Beispiel einstückig mit der ersten Seitenwand 15 und über diese einstückig mit der Grundplatte 14 ausgebildet. Mit anderen Worten, die erste Seitenwand 15 ist durch den ersten Leiterplattenkontakt 4 in negativer z-Richtung unterhalb der Federklemme 10 verlängert.

Der erste Verbindungsabschnitt 17 liegt in der gleichen y-z-Ebene wie die erste Seitenwand 15 und ist an seinem unteren Ende um 90° in die x-y-Ebene als ein zweiter Verbindungsabschnitt 17a umgekantet. Dabei verläuft der zweite Verbindungsabschnitt 17a in positiver x-Richtung. An dem freien Ende des zweiten Verbindungsabschnitts 17a ist die Kontaktfeder 18 angebracht, deren unteres freies Ende in einen kurzen Endabschnitt 19, der in negative x-Richtung weist, umgebogen ist.

Die Übergänge des ersten Verbindungsabschnitts 17 zu dem zweiten Verbindungsabschnitt 17a und des zweiten Verbindungsabschnitts 17a zu der Kontaktfeder 18 verlaufen jeweils in einem Bogen.

Die Kontaktfeder 18 weist eine Kontaktseite 18a auf, welche im Wesentlichen parallel mit der ersten Seitenwand 15 verläuft und in positive x-Richtung weist. In einem unteren Bereich der Kontaktfeder 18 ist ein Kontaktvorsprung 20 angebracht, der von der Kontaktseite 18a hervorsteht. Der Kontaktvorsprung 20 bildet einen Punktkontakt. Der Kontaktvorsprung ist hier vorzugsweise warzenartig ausgebildet.

In einer nicht gezeigten, aber leicht vorstellbaren Ausführung kann auch ein Linienkontakt als Kontaktvorsprung 20 verwendet werden. Ein solcher Linienkontakt erstreckt sich dabei in z-Richtung. Der Linienkontakt kann durchgehend oder unterbrochen sein, wobei er dabei aus mehreren Teillinienstücken besteht Es können auch mehrere Punktkontakte sich hintereinander in Reihe in z-Richtung erstreckend als Kontaktvorsprung 20, 20' vorgesehen sein. Auch eine Kombination aus Punkt-Linien-Kontakten ist möglich. Diese Ausbildungen sind nicht gezeigt aber leicht vorstellbar.

Die zweite Seitenwand, die der ersten Seitenwand 15 gegenüberliegt und parallel zu dieser verläuft, bildet eine Kontaktwand 16 der Federklemme 10.

In einer Ausführungsvariante, die hier nicht gezeigt, aber leicht vorstellbar ist, ist die Grundplatte 14 nicht als eine im Wesentlichen quadratische Platte geformt, sondern weist eine schmale Querplatte auf, die in der oberen oder unteren Hälfte der in Figur 2 gezeigten Grundplattenform die Seitenwände 15 und 16 verbindet.

In Figur 3 ist der erste Leiterplattenkontakt 4 vergrößert gezeigt. Der erste Leiterplattenkontakt 4 ist mit den Verbindungsabschnitten 17, 17a in Bezug auf die erste Seitenwand 15 gekröpft ausgeführt.

Sowohl der Leiterplattenkontakt 4 als auch die Grundplatte 14 mit den Seitenwänden 15 und 16 können als ein Stanzbiegeteil hergestellt sein.

Die Federklemme 10 umfasst einen Federarm 11 mit einem Endabschnitt mit einer Kontaktkante 11a, einen Bogenabschnitt 12, einen Befestigungsabschnitt 13 und die zweite Seitenwand 16 als Kontaktwand.

Der Federarm 11 ist hier mit mehreren gegenläufigen Bögen ausgebildet und über den Bogenabschnitt 12 mit dem Befestigungsabschnitt 13 verbunden.

Der Befestigungsabschnitt 13 verläuft geradlinig parallel in z-Richtung in elektrisch leitendem Kontakt mit der ersten Seitenwand 15 der Grundplatte 14 und ist an der ersten Seitenwand 15 befestigt, z.B. wie hier gezeigt mit Nieten. Andere Befestigungen sind selbstverständlich möglich.

An das obere Ende des Befestigungsabschnitts 13 schließt sich der Bogenabschnitt 12 an, welcher in dem in Figur 2 gezeigten in die Grundplatte 14 eingebauten Zustand einen Winkel von etwa 180° aufweist und dabei gespannt ist. Der Federarm 11 ist auf diese Weise mit seiner Kontaktkante 11a gegen eine zu der ersten Seitenwand 15 weisenden Kontaktseite 16b der zweiten Seitenwand 16 unter Vorspannung des Bogenabschnitts 12 und des Federarms 11 mit seinen Bögen gedrückt.

Die Kontaktseite 16b der Kontaktwand 16 weist zudem längliche Kontaktvorsprünge 16a auf. In dem gezeigten Beispiel sind es zwei Kontaktvorsprünge 16a, die sich in y-Richtung erstrecken. Die Kontaktkante 11a des Endabschnitts liegt in der in Figur 2 gezeigten Stellung der Federklemme 10 ohne geklemmten Leiter zwischen den Kontaktvorsprüngen 16a parallel zu diesen in y-Richtung an der Kontaktseite 16b an.

Eine Innenfläche der Grundplatte 14 und die Kontaktseite 16b der zweiten Seitenwand 16 der Grundplatte 14 bilden einen Anschlussraum 10a für einen in der Federklemme 10 zu klemmenden Leiter 6.

Figur 4 zeigt die Verbindungseinheit 2 nach Figur 2 aus einem anderen Blickwinkel mit Ansicht des Befestigungsabschnitts 13 an der ersten Seitenwand 15.

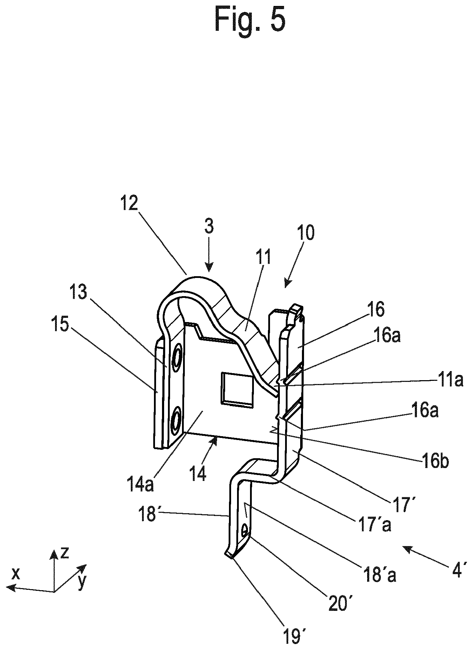

In Figur 5 ist eine schematische Perspektivansichten einer zweiten erfindungsgemäßen Verbindungseinheit 3 der Anschlussvorrichtung 1 nach Figur 1 dargestellt.

Die Federklemme 10 der zweiten Verbindungseinheit 3 entspricht der Federklemme 10 der ersten Verbindungseinheit 2.

Der Aufbau des zweiten Leiterplattenkontaktes 4' ist ähnlich wie derjenige des ersten Leiterplattenkontaktes 4 der ersten Verbindungseinheit 2. Es gibt jedoch Unterschiede.

Im Unterschied zu der ersten Verbindungseinheit 3 ist hier der zweite Leiterplattenkontakt 4' jedoch an dem unteren Ende der zweiten Seitenwand 16 angebracht. Die zweite Seitenwand 16 bildet die Kontaktwand für die Federklemme 10 und gleichzeitig die Anbringung des zweiten Leiterplattenkontaktes 4'. Dabei ist ein unterer Bereich der zweiten Seitenwand 16 über Verbindungsabschnitte 17', 17'a mit der zweiten Kontaktfeder 18' verbunden. Mit anderen Worten, die zweite Seitenwand 16 ist durch den zweiten Leiterplattenkontakt 4' in negativer z-Richtung unterhalb der Federklemme 10 verlängert.

Der zweite Leiterplattenkontakt 4' ist in diesem Beispiel einstückig mit der zweiten Seitenwand 16 und über diese einstückig mit der Grundplatte 14 ausgebildet.

Der erste Verbindungsabschnitt 17' liegt in der gleichen y-z-Ebene der zweiten Seitenwand 16 und ist an seinem unteren Ende um 90° in die x-y-Ebene in positiver x-Richtung verlaufend als ein zweiter Verbindungsabschnitt 17'a umgekantet. An dessen Ende ist die Kontaktfeder 18' angebracht und verläuft in positiver x-Richtung. Das untere freie Ende des zweiten Verbindungsabschnitts17'a ist in einen kurzen Endabschnitt 19', der in positive x-Richtung weist, umgekantet.

Die Übergänge des ersten Verbindungsabschnitts 17' zu dem zweiten Verbindungsabschnitt 17'a und des zweiten Verbindungsabschnitts 17'a zu der zweiten Kontaktfeder 18' verlaufen jeweils in einem Bogen.

Die Kontaktfeder 18' weist eine Kontaktseite 18'a auf, welche im Wesentlichen parallel mit der zweiten Seitenwand 16 verläuft und im Unterschied zu der ersten Kontaktfeder 18 der ersten Verbindungseinheit 2 in positive x-Richtung weist. In einem unteren Bereich der Kontaktfeder 18' ist ein Kontaktvorsprung 20' angebracht, der von der Kontaktseite 18'a hervorsteht. Der Kontaktvorsprung 20' ist auch hier warzenartig ausgebildet.

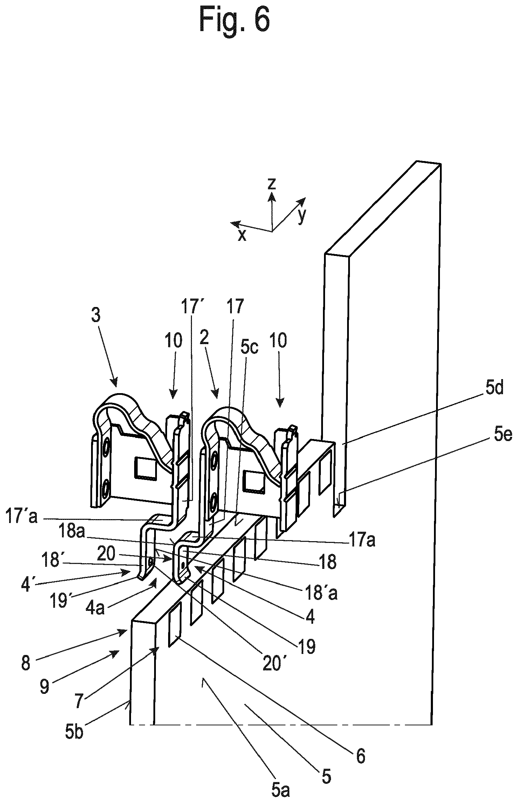

Die zweite Kontaktfeder 18' des zweiten Leiterplattenkontaktes 4' und der zweite Verbindungsabschnitt 17'a sind somit spiegelbildlich zu der ersten Kontaktfeder 18 des ersten Leiterplattenkontaktes 4 der ersten Verbindungseinheit 2 angeordnet im Vergleich der Darstellungen in Figur 4 und 5. Diese spiegelbildliche Anordnung des ersten Leiterplattenkontaktes 4 und des zweiten Leiterplattenkontaktes 4' besteht auch in Anordnung der ersten Verbindungseinheit 2 und der zweiten Verbindungseinheit 3 in den nebeneinanderliegenden Aufnahmen 1b des Gehäuses 1a der Anschlussvorrichtung 1 (siehe Figur 1 und Figur 6).

Auch der zweite Leiterplattenkontakt 4' ist mit den Verbindungsabschnitten 17', 17'a in Bezug auf die zweite Seitenwand 16 gekröpft ausgeführt.

Weitere Unterschiede der Leiterplattenkontakte 4 und 4' werden im Folgenden beschrieben.

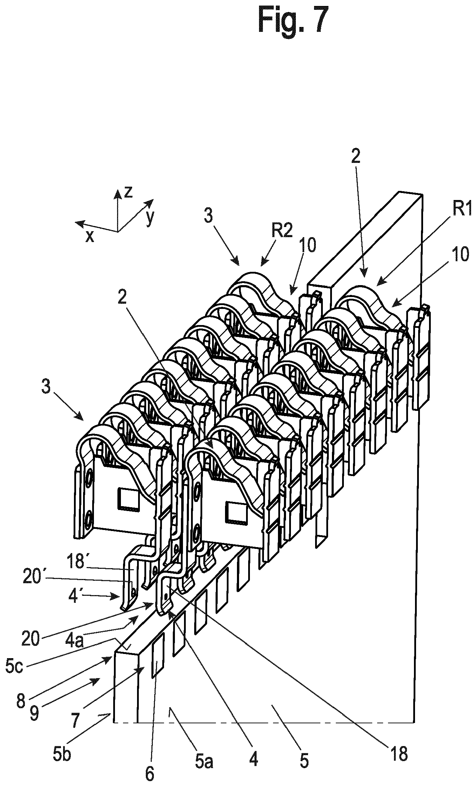

Figur 6 und 7 zeigen schematische Perspektivansichten der ersten und zweiten Verbindungseinheiten 2, 3 nach Figuren 2 bis 5 in der Anordnung in der Anschlussvorrichtung 1 nach Figur 1 ohne das Gehäuse 1a der Anschlussvorrichtung 1.

In Figur 6 ist nur das erste Paar von erster und zweiter Verbindungseinheit 2, 3 dargestellt, wobei Figur 6 alle Verbindungseinheiten 2, 3 in den Reihen R1 und R2 der Anordnung der Anschlussvorrichtung 1 nach Figur 1 ohne das Gehäuse 1a der Anschlussvorrichtung 1 zeigt.

Es ist deutlich zu erkennen, dass der erste Verbindungsabschnitt 17 des ersten Leiterplattenkontaktes 4 länger ist als der erste Verbindungsabschnitt 17' des zweiten Leiterplattenkontaktes 4'. Zudem ist der zweite Verbindungsabschnitt 17a des ersten Leiterplattenkontaktes 4 kürzer ist als der zweite Verbindungsabschnitt 17'a des zweiten Leiterplattenkontaktes 4'. Auf diese Weise ist ein kompakter Aufbau beider Verbindungseinheiten 2 und 3 in dem Gehäuse 1a der Anschlussvorrichtung 1 ermöglicht, wobei die Leiterplattenkontakte 4, 4' stufenförmig angeordnet sind.

Die Kontaktfedern 18, 18' der Leiterplattenkontakte 4 und 4' der Verbindungseinheiten 2 und 3 stehen sich parallel in einem Abstand in x-Richtung gegenüber und legen so eine seitliche Begrenzung des jeweiligen Anschlussraums 4a fest. Weiterhin sind die Anschlussräume 4a in positiver z-Richtung durch den Absatz 1g des Mittelsteges 1f begrenzt.

Auch die Kontaktvorsprünge 20, 20' der Leiterplattenkontakte 4, 4' stehen sich in dem Anschlussraum 4a gegenüber.

Dieser Abstand der Kontaktfedern 18, 18' entspricht der Dicke der Leiterplatte 5 (einschließlich der Kupferbeschichtung) plus einem bestimmten Maß. Dieses bestimmte Maß ist hier in etwa die doppelte Länge des hervorstehenden Kontaktvorsprungs 20, 20' in x-Richtung.

Die Länge des jeweiligen hervorstehenden Kontaktvorsprungs 20, 20' wird in Abhängigkeit von dem vorgesehenen Lötverfahren und dessen Parametern festgelegt. Diese Länge beträgt in diesem Beispiel 0,1 mm. Diese Länge ist gleichzeitig der Abstand der jeweiligen Kontaktseite 18a, 18'a zu der jeweiligen zugehörigen Kontaktfläche 6 der Leiterplatte 5. Dieser Abstand ist für eine korrekte Lötstelle erforderlich, wobei die Kontaktflächen 6 zuvor mit Lotpaste oder/und Flussmittel oder ähnlichem für das vorgesehene Lötverfahren überzogen sind.

Die Kontaktgeometrie der Anschlussvorrichtung 1 umfasst die Federkontakte 4 und 4', welche sich gegenüberstehen und zwischen sich den Anschlussraum 4a festlegen, und die Kontaktvorsprünge 20, 20'.

Bei einem Aufschiebevorgang der Anschlussvorrichtung 1 in Steckrichtung, d.h. in negativer z-Richtung, auf den Anschlussbereich 9 der Leiterplatte 5 erleichtern die umgebogene Endabschnitte 19 der Kontaktfedern 18, 18' ein Einfädeln der Oberseite 5c des Anschlussbereiches 9 in die Anschlussräume 4a. Dann kontaktieren die warzenförmigen Kontaktvorsprünge 20, 20' der Kontaktfedern 18, 18' die zugehörigen Kontaktflächen 6 der Leiterplatte 5 in einer jeweiligen Punktberührung. Dabei ergibt sich der Vorteil, dass das auf den Kontaktflächen 6 befindliche Flussmittel oder Lotpaste nicht entfernt oder weggeschoben wird, außer im Berührungsbereich des Kontaktvorsprungs 20, 20'. Dieser Vorteil ergibt sich auch, wenn der Kontaktvorsprung 20, 20' linienförmig und sich in z-Richtung erstreckend ausgebildet ist. Es können auch mehrere Punktkontakte sich hintereinander in Reihe in z-Richtung erstreckend als Kontaktvorsprung 20, 20' vorgesehen sein. Zudem kann ein über die Kontaktflächen 6 verteilter gleichmäßiger Abstand zu den Kontaktfedern 18, 18' der Leiterplattenkontakte 4, 4' für das vorgesehene Lötverfahren eingehalten werden und fehlerfreie Lötstellen ermöglichen.

Weiterhin stehen die Kontaktfedern 18, 18' unter leichter Vorspannung in x-Richtung aufeinander und werden beim Aufschieben der Anschlussvorrichtung 1 auf den Anschlussbereich 9 der Leiterplatte 5 etwas weiter gespannt. Diese Vorspannkraft hat den weiteren Vorteil, dass die Anschlussvorrichtung 1 in ihrer Stellung auf der Leiterplatte 5 soweit fixiert ist, dass sie sich beim Lötvorgang nicht verschieben kann.

In Figur 6 ist der Anschlussbereich 9 mit der Oberseite 5c des Randes der Leiterplatte 5 hier auf einer Seite in positiver y-Richtung durch einen Schlitz 5d, der einen Boden 5e aufweist, begrenzt. Dieser Schlitz 5d dient zur Fixierung der Anschlussvorrichtung 1 in einer Verbindungsstellung. Mittels dieser Fixierung, die beispielhaft im Zusammenhang mit Figur 8 noch erläutert wird, ist es möglich, dass die Leiterplattenkontakte 4, 4' der Anschlussvorrichtung 1 in Bezug auf die zugehörigen Kontaktflächen 6 der Leiterplatte 5 verpolungssicher und präzise positioniert werden.

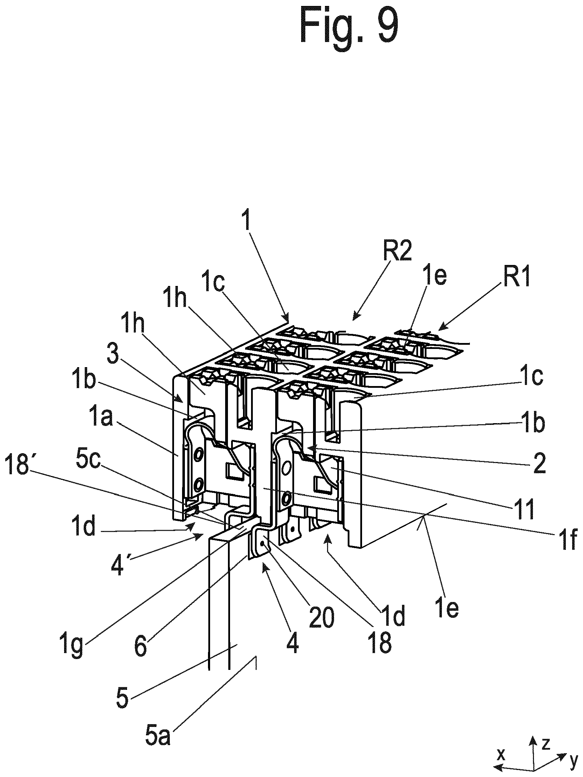

Figur 8 zeigt eine schematische Perspektivansicht der Anschlussvorrichtung 1 nach Figur 1 in einer Verbindungsstellung. In Figur 9 ist eine vergrößerte Darstellung des Bereichs IX aus Figur 8 gezeigt.

In der Verbindungsstellung steht die Oberseite 5c des Randes der Leiterplatte 5 mit dem Absatz 1g bzw. Schulter des Mittelstegs 1f des Gehäuses 1a der Anschlussvorrichtung 1 in Kontakt. Der Absatz 1g des Mittelstegs 1f verläuft in y-Richtung. Damit wird ein Anschlag der Anschlussvorrichtung 1 an der Leiterplatte 5 in negativer z-Richtung gebildet.

Es ist zudem in Figur 8 deutlich zu erkennen, dass die gekröpften Leiterplattenkontakte 4, 4' den Vorteil erbringen, dass der Anschlussraum 4a so angeordnet werden kann, dass die Oberseite 5c der Leiterplatte 5 unter dem Absatz 1g des Mittelsteges 1f des Gehäuses 1a der Anschlussvorrichtung 1 liegt.

Eine Unterseite der Rückseitenwand RS des Gehäuses 1a der Anschlussvorrichtung 1 liegt in der Verbindungsstellung auf dem Boden 5e des Schlitzes 5d (Figur 6) des Randes der Leiterplatte 5 auf. Damit wird ein zusätzlicher Anschlag in negativer z-Richtung gebildet, wobei gleichzeitig eine Fixierung der Anschlussvorrichtung 1 in y-Richtung durch Formschluss der Rückseitenwand RS mit dem Schlitz 5d der Leiterplatte 5 (siehe Figur 6) ermöglicht ist.

Nachdem die Anschlussvorrichtung 1 in der Verbindungsstellung mit der zugehörigen Leiterplatte 5 durch den vorgesehenen Lötvorgang verbunden ist, verbindet die Anschlussvorrichtung 1 die dann an sie angeschlossenen Leiter L mittels der zugehörigen Verbindungseinheiten 2, 3 über die Federklemmen 10 und die Leiterplattenkontakte 4, 4' mit den zugehörigen Kontaktflächen 6 der Leiterplatte 5.

Die Leiter L sind durch die ersten Öffnungen 1c der Oberseite des Gehäuses 1a der Anschlussvorrichtung 1 geführt in die jeweiligen Anschlussräume10a der Federklemme 10 der Verbindungseinheiten 2, 3 aufgenommen und durch den Federarm 11 der jeweiligen Federklemme 10 an die Kontaktseite 16b der zweiten Seitenwand 16 geklemmt. Dazu wurde zuvor der Federarm 11 der Federklemme 10 durch einen Betätiger 1h nach unten in z-Richtung gedrückt, um ein Einschieben des jeweiligen Leiters L in den Anschlussraum 10a zu erleichtern. Es ist auch möglich, dass der Leiter L ohne Drücken des Betätigers 1h in die Federklemme 10 eingeschoben werden kann.

Nach Freigabe des Betätigers 1h drückt der Federarm 11 mit seiner Kontaktkante 11a den Leiter L gegen die Kontaktvorsprünge 16a und die Kontaktseite 16b der zweiten Seitenwand 16.

Eine elektrisch leitende Verbindung des Leiters L und des Leiterplattenkontaktes 4, 4' ist auf diese Weise zwischen der Federklemme 10 und dem jeweiligen Leiterplattenkontakt 4, 4' mittels der elektrisch leitenden Grundplatte 14 der Verbindungseinheit 2, 3, mit welcher sowohl die Federklemme 10 als auch der jeweilige Leiterplattenkontakt 4, 4' elektrisch leitend verbunden sind, hergestellt.

Die Erfindung ist nicht auf die oben erläuterten Ausführungsbeispiele beschränkt. Im Rahmen der angefügten Ansprüche ist die Erfindung modifizierbar.

### Bezugszeichen

- 1: Anschlussvorrichtung
- 1a: Gehäuse
- 1b: Aufnahme
- 1c, 1d: Öffnung
- 1e: Betätiger
- 1f: Mittelsteg
- 1g: Absatz
- 1h: Betätiger
- 2,3: Verbindungseinheit
- 4,4': Leiterplattenkontakt
- 4a: Anschlussraum
- 5: Leiterplatte
- 5a, 5b: Leiterplattenseite
- 5c: Oberseite
- 5d: Schlitz
- 5e: Boden
- 6: Kontaktfläche
- 7,8: Kontaktanordnung
- 9: Anschlussbereich
- 10: Federklemme
- 10a: Anschlussraum
- 11: Federarm
- 11a: Endabschnitt
- 12: Bogenabschnitt
- 13: Befestigungsabschnitt
- 14: Grundplatte
- 14a: Basis
- 14b: Wandabschnitt
- 14c: Vorsprung
- 15: Seitenwand
- 16: Seitenwand
- 16a: Kontaktvorsprung
- 16b: Kontaktseite
- 16c: Bodenabschnitt
- 17, 17a; 17', 17'a: Verbindungsabschnitt
- 18, 18': Kontaktfeder
- 18a, 18'a: Kontaktseite
- 19, 19': Endabschnitt
- 20, 20': Kontaktvorsprung

- L: Leiter
- RS: Rückseitenwand
- R1, R2: Anschlussreihe
- VS: Vorderseitenwand
- x, y, z: Koordinaten

## Patentansprüche

1. Anschlussvorrichtung (1) zur Verbindung mindestens eines elektrischen Leiters (L) mit mindestens einer elektrisch leitenden Kontaktfläche (6) einer Leiterplatte (5), aufweisend ein Gehäuse (1a), mindestens eine erste Verbindungseinheit (2) und mindestens eine zweite Verbindungseinheit (3), wobei die Anschlussvorrichtung (1) eine SMD-fähige Kontaktgeometrie aufweist,
**dadurch gekennzeichnet, dass** die SMD-fähige Kontaktgeometrie mindestens einen ersten Leiterplattenkontakt (4) und mindestens einen zweiten Leiterplattenkontakt (4') mit jeweils einem Federarm (18, 18') mit einem jeweiligen Kontaktvorsprung (20, 20') aufweist.

2. Anschlussvorrichtung (1) nach Anspruch 1, **dadurch gekennzeichnet, dass** die Kontaktvorsprünge (20, 20') jeweils mindestens einen Punktkontakt bilden.

3. Anschlussvorrichtung (1) nach Anspruch 1 oder 2, **dadurch gekennzeichnet, dass** die Kontaktvorsprünge (20, 20') jeweils einen Linienkontakt bilden, der sich in Steckrichtung der Anschlussvorrichtung (1) erstreckt.

4. Anschlussvorrichtung (1) nach einem der vorstehenden Ansprüche, **dadurch gekennzeichnet, dass** der mindestens eine erste Leiterplattenkontakt (4) mit dem einen Kontaktvorsprung (20) und der mindestens eine zweite Leiterplattenkontakt (4') mit dem einen Kontaktvorsprung (20') gegenüberstehend angeordnet sind, wobei sie einen Anschlussraum (4a) zur Aufnahme eines Anschlussbereiches (9) der zuzuordnenden Leiterplatte zwischen sich festlegen.

5. Anschlussvorrichtung (1) nach Anspruch 4, **dadurch gekennzeichnet, dass** der Anschlussraum (4a) weiterhin durch einen Mittelsteg (1f) des Gehäuses (1a) der Anschlussvorrichtung (1) begrenzt ist.

6. Anschlussvorrichtung (1) nach einem der vorstehenden Ansprüche, **dadurch gekennzeichnet, dass** die mindestens eine erste Verbindungseinheit (2) und die mindestens eine zweite Verbindungseinheit (3) jeweils in einer Aufnahme (1b) des Gehäuses (1a) eingesetzt sind, wobei eine jede Aufnahme (1b) mindestens eine erste Öffnung (1c) an einer Oberseite des Gehäuses (1a) für den mindestens einen elektrischen Leiter (L) und mindestens eine zweite Öffnung (1d), durch welche sich der Federarm (18, 18') des jeweiligen Leiterplattenkontaktes (4, 4') hindurch erstreckt, an einer Unterseite (1e) des Gehäuses (1a) aufweist.

7. Anschlussvorrichtung (1) nach einem der vorstehenden Ansprüche, **dadurch gekennzeichnet, dass** der Federarm (18) des ersten Leiterplattenkontaktes (4) an einer ersten Seitenwand (15) der mindestens einen ersten Verbindungseinheit (2) angebracht ist, und dass der Federarm (18') des zweiten Leiterplattenkontaktes (4') an einer zweiten Seitenwand (16) der mindestens einen zweiten Verbindungseinheit (3) angebracht ist.

8. Anschlussvorrichtung (1) nach Anspruch 7, **dadurch gekennzeichnet, dass** die mindestens eine erste Verbindungseinheit (2) und die mindestens eine zweite Verbindungseinheit (3) derart in benachbarten Aufnahmen (1b) angeordnet sind, dass ein Mittelsteg (1f) des Gehäuses (1a) der Anschlussvorrichtung (1) zwischen der ersten Seitenwand (15) der mindestens einen ersten Verbindungseinheit (2) mit dem Federarm (18) des ersten Leiterplattenkontaktes (4) und der zweiten Seitenwand (16) der mindestens einen zweiten Verbindungseinheit (3) mit dem Federarm (18') des zweiten Leiterplattenkontaktes (4') angeordnet ist.

9. Anschlussvorrichtung (1) nach Anspruch 8, **dadurch gekennzeichnet, dass** die mindestens eine erste Verbindungseinheit (2) und die mindestens eine zweite Verbindungseinheit (3) jeweils eine Grundplatte (14) mit der ersten Seitenwand (15) und mit der zweiten Seitenwand (16) aufweisen, wobei die erste Seitenwand (15) und die zweite Seitenwand (16) parallel zueinander und rechtwinklig an der Grundplatte (14) angebracht und durch die Grundplatte (14) elektrisch leitend verbunden sind.

10. Anschlussvorrichtung (1) nach Anspruch 9, **dadurch gekennzeichnet, dass** die mindestens eine erste Verbindungseinheit (2) und die mindestens eine zweite Verbindungseinheit (3) jeweils eine Federklemme (10) zum Anschluss des mindestens einen Leiters (L) aufweist, wobei die Federklemme (10) einen Federarm (11) mit einer Kontaktkante (11a) und einer Kontaktwand umfasst, wobei die Kontaktwand die zweite Seitenwand (16) ist.

11. Anschlussvorrichtung (1) nach Anspruch 10, **dadurch gekennzeichnet, dass** der Federarm (11) der Federklemme (10) über einen Bogenabschnitt (12) mit einem Befestigungsabschnitt (13), welcher an der ersten Seitenwand (15) der Grundplatte (14) elektrisch leitend angebracht ist, verbunden ist.

12. Anschlussvorrichtung (1) nach Anspruch 11, **dadurch gekennzeichnet, dass** das Gehäuse (1a) einen Betätiger (1h) oder/und einen Betätigungskanal für ein Werkzeug zur Betätigung der Federklemme (10) einer jeweiligen Verbindungseinheit (2, 3) aufweist.

13. Verbindungseinheit (2, 3) einer Anschlussvorrichtung (1) nach einem der vorstehenden Ansprüche zur Verbindung mindestens eines elektrischen Leiters (L) mit mindestens einer elektrisch leitenden Kontaktfläche (6) einer Leiterplatte (5), einer Federklemme (10) und einem Leiterplattenkontakt (4, 4'),
**dadurch gekennzeichnet, dass**
die Verbindungseinheit (2, 3) eine Grundplatte (14) mit einer ersten Seitenwand (15) und mit einer zweiten Seitenwand (16) aufweist, wobei die erste Seitenwand (15) und die zweite Seitenwand (16) parallel zueinander und rechtwinklig an der Grundplatte (14) angebracht und durch die Grundplatte (14) elektrisch leitend verbunden sind.

14. Verbindungseinheit (2, 3) nach Anspruch 13, **dadurch gekennzeichnet, dass** die Federklemme (10) einen Federarm (11) mit einer Kontaktkante (11a) und einer Kontaktwand umfasst, wobei die Kontaktwand die zweite Seitenwand (16) ist, und wobei der Federarm (11) der Federklemme (10) über einen Bogenabschnitt (12) mit einem Befestigungsabschnitt (13), welcher an der ersten Seitenwand (15) der Grundplatte (14) elektrisch leitend angebracht ist, verbunden ist.

15. Verbindungseinheit (2) nach Anspruch 14, **dadurch gekennzeichnet, dass** der Federarm (18) des Leiterplattenkontaktes (4) an der ersten Seitenwand (15) der Verbindungseinheit (2) angebracht ist, wodurch die erste Seitenwand (15) durch den Leiterplattenkontakt (4) unterhalb der Federklemme (10) verlängert ist.

16. Verbindungseinheit (3) nach Anspruch 14, **dadurch gekennzeichnet, dass** der Federarm (18') des Leiterplattenkontaktes (4') an der zweiten Seitenwand (16) der Verbindungseinheit (3) angebracht ist, wodurch die zweite Seitenwand (16) durch den Leiterplattenkontakt (4') unterhalb der Federklemme (10) verlängert ist.

17. Verbindungseinheit (3) nach Anspruch 15 oder 16, **dadurch gekennzeichnet, dass** die Leiterplattenkontakte (4, 4') der Verbindungseinheiten (2, 3) mit Verbindungsabschnitten (17, 17'; 17a, 17'a) gekröpft ausgeführt ist.
